# EUROPEAN PATENT APPLICATION

(11) **EP 4 788 117 A2**
(43) Date of publication of application: **05.08.2026**
(21) Application number: 26152921.8
(22) Date of filing: 20.01.2026
(51) Int. Cl.: H10W 74/00, H10W 76/48, H10W 90/10, H10W 90/00

(54) **CORROSION RESISTANT POWER ELECTRONIC MODULES**

(30) Priority: 29.01.2025 US 202519040487
(71) Applicant: Rockwell Automation Technologies, Inc., Mayfield Heights, OH 44124 (US)
(72) Inventor: Kaminski, Daniel T., Mayfield Heights, OH 44124 (US)
(74) Representative: Grünecker Patent- und Rechtsanwälte PartG mbB

(57) **Abstract**

Disclosed is a corrosion resistant power electronic module having a metal-ceramic substrate including a ceramic layer and a metallic layer, where the metallic layer includes metal bonded to the ceramic layer such that trenches are formed between portions of the metal through which the surface of the ceramic layer is exposed. In a first embodiment, portions of the exposed surface of the ceramic layer are melted in the trenches to modify the surface layer, lowering the roughness, which inhibits corrosion growth in corrosive gas environments. In a second embodiment, a barrier material is disposed within the trenches and bonded to the exposed surface of the ceramic layer such that once bonded, the barrier material does not physically contact the metal of the metallic layer. In a third embodiment, the ceramic layer comprises a high density, ultra-low roughness ceramic insulator.

## Description

### BACKGROUND

Metal-ceramic substrate circuit carriers are used in the assembly of power electronic modules (also called power electronic components or power electronic devices) such as insulated-gate bipolar transistor (IGBT) power modules, diode rectifier modules, silicon controlled rectifier (SCR) modules, high power light emitting diode (LED) components, high concentration photovoltaic devices, and the like. Often, these types of power electronic modules are used to convert power from one form to another such as rectifying alternating current (AC) to direct current (DC) or inverting DC to AC. Such power conversion is necessary in many industries and systems, including, for example, variable frequency motor drives for industrial automation. Industrial automation environments often require use of these power electronic modules in corrosive gas environments. These corrosive gas environments can lead to corrosion within the power electronic modules. Power electronic modules are generally not designed to be air-tight and instead often contain an intentionally perforated or imperfectly sealed plastic housing. A silicone-based potting material (i.e., encapsulation material) is placed inside the housing that covers (i.e., encapsulates) the metal-ceramic substrate, connection wires, semiconductors (i.e., chips), and any other internal elements inside the plastic housing from outside the plastic housing. While several properties of silicone-based potting materials, such dielectric strength, thermal stability, and shielding against liquid or solid particle contamination, are exceptionally well suited for use in power electronic modules, one major drawback to the silicone-based potting materials is permeability to corrosive gases and humidity over time. Accordingly, corrosive gases and humidity from a corrosive gas environment may contact the sensitive semiconductors, connection wires, and ceramic surfaces within the power electronic module.

Damage caused by corrosion within power electronics modules can occur when their internal metals react with a corrosive gas environment in which they are used and can lead to electrical bridging between metals that were designed to be electrically separated. A common form of corrosion that occurs is copper or silver metal reacting with sulfur-bearing gases and humidity leading to formation of copper sulfide and silver sulfide compounds. These compounds are known to be electrically conductive and tend to grow in tree-like shapes in the direction of electrical fields. Once growth of the tree-like shapes occurs from one metal to another that are at different voltages, electrical shorting or arcing occurs. Due to relatively high power levels that can be present inside of power electronic modules, the electrical shorting or arcing can be catastrophic and damaging to the power electronic module itself, adjacent or connected devices, and even to personnel working nearby.

Gases corrosive to power electronic modules include hydrogen sulfide, sulfur dioxide, chlorine, nitrogen dioxide, elemental sulfur vapor, water vapor, and the like. Often, the level of corrosive gas concentration detrimental to power electronic modules are well below governing body action limits, such as Occupational Safety and Health Administration (OSHA), for employees working in and near such environments. These corrosive gas environments may be found in the rubber industry, oil and gas industry, pulp and paper industry, extractive metallurgy/smelting industries, mining industry, food and beverage industries (e.g., brewing), and the like.

To date, methods and techniques used to protect power electronic modules against corrosive gas environments have been limited and have not addressed a key factor that leads to the rapid and tree-like directional growth of the electrically conductive corrosion compounds such as copper sulfide and silver sulfide. Accordingly, improvements are needed.

### SUMMARY

Power electronic modules used in corrosive gas environments are particularly vulnerable to corrosion across the trenches formed between conductive metal portions of the metallic layer of the metal-ceramic substrate. The trenches expose the surface of the insulating ceramic layer to the corrosive gas. The tree-like corrosion starts at the surface layer of the ceramic layer, fueled by the voltage potential differences between the metal on one side of the trench and the metal on the other side of the trench. The roughness of the surface of the ceramic layer is found to impact the ability of the corrosion to spread across the ceramic layer. By modifying the exposed surface of the ceramic layer within the trench, the corrosion is inhibited.

One way to modify or smooth the surface of the ceramic layer is to modify the surface layer of at least a portion of the exposed surface. The surface may be smoothed by melting the surface layer and allowing the melted portion to harden. The surface may be melted by applying a chemical component, applying directed energy (e.g., a laser), or any other suitable melting technique. By smoothing at least a portion of the bottom of the trench, the corrosion growth is inhibited.

A second way to modify the surface of the ceramic layer is to add a barrier material within the trench, bonded to the exposed surface of the ceramic layer. The barrier material inhibits corrosion by smoothing the exposed surface of the trench as well as expanding the distance the corrosion must travel. The barrier material is bonded to the surface of the ceramic layer, but once bonded, it does not touch the metal forming the sides of the trench. This separation ensures that the barrier material does not crack or otherwise suffer structural degradation.

A third way to modify the surface of the ceramic layer is to use a high density, ultra-low surface roughness ceramic insulator for the ceramic layer. In most power electronic modules, the ceramic layer is a 96% aluminum oxide ceramic material, which has a surface layer roughness value (Ra) of approximately 0.4 microns. A high density, ultra-low surface roughness ceramic insulating material, which has a surface layer roughness value (Ra) of 0.25 or less and ideally 0.10 Ra or less, inhibits corrosion growth.

More technically, an embodiment of a system includes a power electronic module. The power electronic module includes a ceramic layer and a metallic layer. The metallic layer may include a metal joined to the ceramic layer, and trenches extending the depth of the metal and separating the metal into portions such that one side of the trenches is defined by a surface of the ceramic layer and two opposite sides of the trenches are defined by the metal. The power electronic module further includes a strand of barrier material disposed within the trenches of the metallic layer, where the strand of barrier material is bonded to at least a portion of the surface of the ceramic layer defining the one side of the trenches, and the strand of barrier material does not physically contact the metal defining the two opposite sides of the trenches once bonded to the surface of the ceramic layer. Other embodiments of this system include methods for assembling or creating the claimed power electronic module.

Implementations may include one or more of the following features. Optionally, the barrier material is one of a glass, a glass-ceramic, and a polymeric material. Optionally, the coefficient of thermal expansion of the barrier material is substantially the same as the coefficient of thermal expansion of the ceramic layer. Optionally, the metal is copper, aluminum, or a metal alloy. Optionally, the metal is plated with a non-oxidizing material (e.g., nickel). When the metal is plated, the strand of barrier material does not physically contact the non-oxidizing material once bonded to the surface of the ceramic layer. Optionally, the ceramic layer is alumina, zirconia-toughened alumina, aluminum nitride, silicon nitride, or beryllia.

Another embodiment includes a method for modifying a metal-ceramic substrate with a barrier material. The metal-ceramic substrate may include a ceramic layer and a metallic layer. The metallic layer may include a metal joined to the surface of the ceramic layer and trenches separating portions of the metal through which portions of the surface of the ceramic layer are exposed. The method includes applying the barrier material, which may include placing the barrier material within the trenches, heating the barrier material to a flow point, and cooling the barrier material to form the strand of barrier material. After cooling, the strand of barrier material is thermally bonded to at least a portion of the surface of the ceramic layer exposed within the trenches. Further, after cooling, the strand of barrier material does not physically contact the portions of the metal separated by the trenches.

Implementations may include one or more of the following features. Optionally, the barrier material is glass, a glass-ceramic, or a polymeric material. Optionally, the method may include selecting the barrier material such that a coefficient of thermal expansion of the barrier material is substantially the same as the coefficient of thermal expansion of the ceramic layer. Optionally, the metal is plated with a non-oxidizing material, and after cooling, the strand of barrier material does not physically contact the non-oxidizing material. Optionally, the ceramic layer is alumina, zirconia-toughened alumina, aluminum nitride, silicon nitride, or beryllia. Optionally, the method may include assembling the metal-ceramic substrate. Optionally, a melting temperature of the barrier material defines the flow point, and the melting temperature of the barrier material is less than the melting temperature of the metal and of the ceramic layer. Heating the barrier material may include baking the metal-ceramic substrate in an oven set to a temperature exceeding the melting temperature of the barrier material but not exceeding the melting temperature of the metal or the ceramic layer.

Yet another embodiment includes a method for smoothing the surface layer of a portion of a ceramic layer of a power electronic module. The power electronic module may include the ceramic layer and a metallic layer. The metallic layer may include a metal joined to portions of a surface of the ceramic layer, and trenches separating portions of the metal through which the surface of the ceramic layer is exposed. The smoothing may include melting the surface layer of at least a portion of the exposed surface of the ceramic layer in the trenches, and allowing the melted surface layer to harden such that the at least the portion of the exposed surface of the ceramic layer may include a surface roughness less than the surface roughness of unsmoothed portions of the ceramic layer.

Implementations may include one or more of the following features. Optionally, melting the surface layer may include applying a chemical to the at least the portion of the exposed surface of the ceramic layer. Optionally, melting the surface layer may include applying directed energy to the at least the portion of the exposed surface of the ceramic layer. Applying the directed energy may include directing a beam of a laser along the trench. Optionally, the laser is a type of laser that melts the ceramic layer and does not melt the metal. Optionally, applying directed energy may include avoiding applying the directed energy to the metal. Optionally, the ceramic layer may include alumina, zirconia-toughened alumina, aluminum nitride, silicon nitride, or beryllia.

### BRIEF DESCRIPTION OF THE DRAWINGS

The patent or application file contains at least one drawing executed in color. Copies of this patent or patent application publication with color drawing(s) will be provided by the Office upon request and payment of the necessary fee.

Many aspects of the disclosure can be better understood with reference to the following drawings. The components in the drawings are not necessarily drawn to scale. Moreover, in the drawings, like reference numerals designate corresponding parts throughout the several views. While several embodiments are described in connection with these drawings, the disclosure is not limited to the embodiments disclosed herein. On the contrary, the intent is to cover all alternatives, modifications, and equivalents.
FIG. 1 illustrates a cross-sectional view of a power electronic module, according to some embodiments.
FIG. 2A illustrates corrosion expanding across a trench of a power electronic module.
FIG. 2B illustrates an enlarged view of tree-like corrosion expanding across a trench of a power electronic module.
FIG. 3 illustrates an exemplary cross-sectional view of a portion of a metal-ceramic substrate having a modified surface layer of exposed portions of the ceramic layer within a trench, according to some embodiments.
FIG. 4 illustrates a top view of an exemplary metal-ceramic substrate depicting a laser path for modifying the surface layer of exposed portions of the ceramic layer within the trench, according to some embodiments.
FIG. 5 illustrates a top view and an enlarged view of a portion of a metal-ceramic substrate having a modified surface layer of exposed portions of the ceramic layer within a trench according to some embodiments.
FIG. 6 illustrates an exemplary cross-sectional view of a portion of a metal-ceramic substrate having a barrier material disposed within a trench, according to some embodiments.
FIG. 7 illustrates a top view of an exemplary metal-ceramic substrate depicting a barrier material bonded to exposed portions of the ceramic layer within the trench, according to some embodiments.
FIG. 8 illustrates an enlarged, cross-sectional view of a portion of a metal-ceramic substrate having a barrier material bonded to the ceramic layer within a trench, according to some embodiments.
FIG. 9 illustrates an exemplary cross-sectional view of a portion of a metal-ceramic substrate having an ultra-low surface roughness ceramic layer, according to some embodiments.
FIG. 10 illustrates enlarged views and a roughness comparison graph of ceramic layers, according to some embodiments.
FIG. 11 illustrates a method for adding a barrier material to the trenches of a metal-ceramic substrate, according to some embodiments.
FIG. 12 illustrates a method for melting the surface layer of portions of the exposed surface layer of the ceramic layer of a metal-ceramic substrate, according to some embodiments.

### DETAILED DESCRIPTION

Metal-ceramic substrates in power electronic modules are vulnerable to corrosion in corrosive environments at least in part because they are not tightly sealed. Many attempts to solve the corrosion problem in metal-ceramic substrates have focused on sealing the power electronic module to limit entry of corrosive gases. When power electronic modules that have suffered corrosion are inspected, one sees that the pathway along which tree-like corrosion growth advances is in the trenches. The trenches are electrically insulating areas that serve to insulate the portions of the metal separated by the trenches from each other. The ceramic layer is an insulating material, and the voltage potential difference between the metal portions encourage the corrosion growth along the surface of the ceramic layer within the trenches. Corrosion is limited or eliminated by creating a smoother, more void-free surface of the ceramic layer exposed within the trenches.

Embodiments described herein include three options for ensuring that the exposed surface of the ceramic layer within the trenches is smoother and more void-free. Accordingly, the pathways along which the corrosion expands are restricted or eliminated. Note here that the term "exposed" is used to describe the portion of the surface of the ceramic layer within the trenches of the metal-ceramic substrate throughout this disclosure. It should be understood that during manufacturing, while the metal-ceramic substrate is assembled, the surface of the ceramic layer is exposed in the trenches from a top-down view. Once the power electronic module is more completely assembled, the encapsulation material (e.g., silicone-based potting material) fills the area within the housing and bonds to the exposed surface of the ceramic layer within the trenches, and therefore the ceramic layer is no longer visually exposed. However, since the encapsulation material does not withstand the permeation of corrosive gases, the surface of the ceramic layer within the trenches and bonded to the encapsulation material is still exposed to gases. Accordingly, the methods described herein are generally performed during assembly of the metal-ceramic substrate, typically before semiconductors, terminals, and any other internal elements are attached for further assembly of the power electronic module.

In a first embodiment, the trenches of the metallic layer are modified to smooth the surface layer of the exposed ceramic layer. In standard power electronic modules, a 96% aluminum oxide ceramic material is used for the ceramic layer. This type of ceramic layer generally has a surface roughness value (Ra) of approximately 0.4 microns. However, this surface roughness value can be substantially reduced by melting the surface layer of the ceramic layer. For example, a laser may be used to melt the surface layer along the trenches. Once cooled and hardened, the surface layer of the ceramic layer is smoother and more void-free. In some embodiments, a chemical may be used to melt the surface layer. Testing shows a 2.5 - 3 times improvement in resisting corrosion over non-smoothed power electronic components.

In another embodiment, a high density ultra-low surface roughness ceramic insulator is used for the ceramic layer. By using a ceramic layer with a smoother surface to begin with, no particular modification after or during assembly are needed. For example, a 99% ceramic material may be used for the ceramic layer. The surface roughness value of the ceramic layer may be 0.25 microns Ra or less and ideally may be 0.10 microns Ra or less. Using a high density, ultra-low surface roughness ceramic insulator shows a 2.5 - 3 times improvement in resisting corrosion over a metal-ceramic substrate using a 96% aluminum oxide ceramic material for the ceramic layer.

In yet another embodiment, a barrier material is disposed on the exposed surface of the ceramic layer within the trenches. The barrier material is heated to a flow point and, on cooling, bonds to the surface of the ceramic layer within the trenches. Further, the barrier material does not physically contact the metal forming the sides of the trenches once cooled. The barrier material is a glass or polymer material that is smooth when cooled and hardened. Tests show that metal-ceramic substrates using a barrier material as described herein show a greater than 10 times improvement over metal-ceramic substrates having no barrier material.

Improvements described herein provide for limiting or eliminating corrosion within a power electronic module. Avoiding and limiting corrosion allows power electronic modules to be used in corrosive gas environments more safely. Rather than limiting the entry of the corrosive gases into the power electronic module, the corrosion growth pathway is improved to reduce or eliminate risk of electrical shorting or arcing, improving safety and reliability. Further, the disclosed invention can be implemented without modifying the way the power electronic modules are currently used and implemented. Accordingly, the techniques may be implemented during assembly and manufacture of the power electronic modules, and the improved power electronic modules may be used in place of those not improved by the disclosed techniques, allowing for immediate improvement in systems.

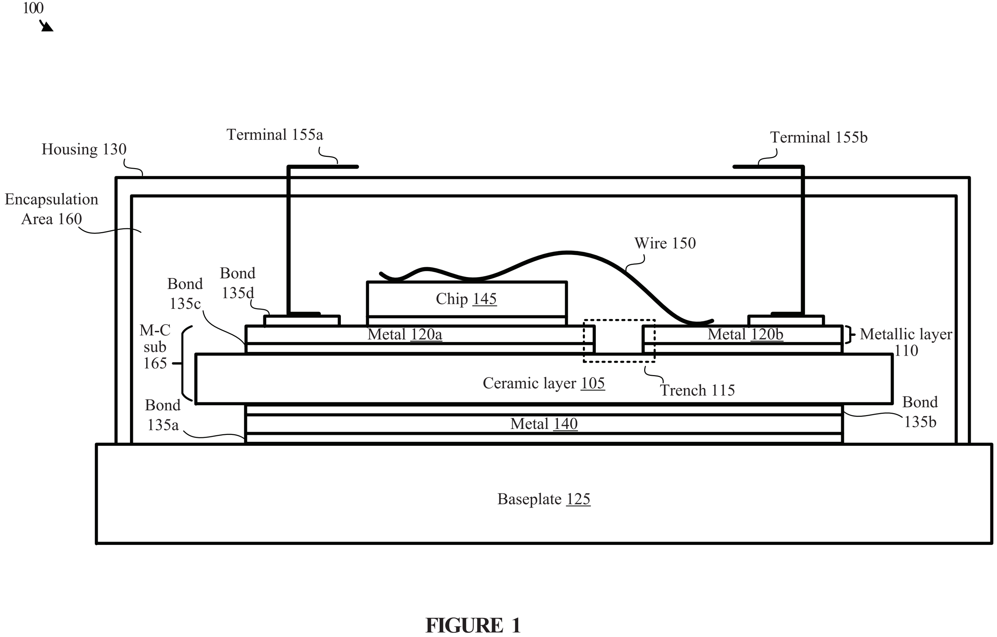

Turning now to the FIGS, **FIG. 1** illustrates an exemplary cross sectional diagram of a power electronic module 100. The power electronic module includes ceramic layer 105, metallic layer 110, trench 115, metal 120a, metal 120b, baseplate 125, housing 130, bond 135a, bond 135b, bond 135c, bond 135d, metal 140, chip 145, connection wire 150, terminal 155a, terminal 155b, encapsulation area 160, and metal-ceramic substrate 165. Power electronic module 100 is representative of a power electronic module, though the thickness of layers and number of components may vary based on particular design of a given power electronic module.

Baseplate 125 may be a substrate material forming the base of power electronic module 100. Baseplate 125 may be a heatsink such that it may be coupled to a larger electronic system and thermal energy may be dissipated through baseplate 125 to an external heatsink. Bond 135a may be any bonding material, adhesive, or solder used to join metal 140 to baseplate 125. Metal 140 may be any metallic, electrically conductive material. For example, metal 140 may be copper, aluminum, or a metal alloy. Metal 140 may be plated, for example, with a non-oxidizing material. For example, metal 140 may be nickel-plated or gold-plated, in some embodiments. Bond 135b may be any bonding material, adhesive, or solder used to join metal 140 to ceramic layer 105. Bond 135b represents any bonding used to join metal 140 to ceramic layer 105. For example, metal 140 may be joined to ceramic layer 105 using direct bonding, active brazing, regular brazing, direct aluminum bonding, direct copper bonding, or the like. In some embodiments, metal 140 is not included in power electronic module 100. Metal 140 may be used to dissipate heat from within power electronic module 100 to baseplate 125 for external or further dissipation.

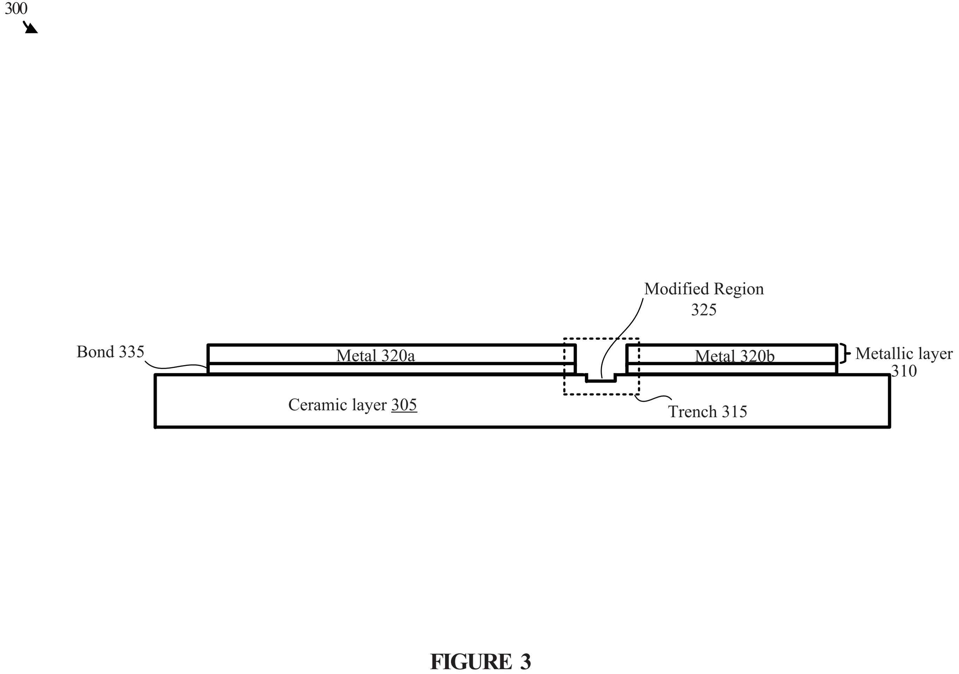

Ceramic layer 105 may be any insulating material, which may form the base of metal-ceramic substrate 165. For example, ceramic layer 105 may be a ceramic sheet formed from any suitable ceramic material including, for example, aluminum oxide, aluminum nitride, zirconia-toughened aluminum oxide, aluminum nitride, silicon nitride, and beryllium oxide. Ceramic layer 105 may be any suitable thickness. For example, in many applications, ceramic layer 105 may be approximately 0.025 inches thick. Ceramic layer 105 may be any suitable purity including, for example 90 wt%, 96 wt%, 98 wt%, or 99 wt% purity. The thickness, material, and purity may all be selected for the particular application. Each has benefits and drawbacks based on properties including thermal conductivity, fracture resistance, cost, and toxicity. Without the benefit of the advancements disclosed herein, ceramic layer 105 is commonly an aluminum oxide sheet used "as fired" (i.e., not ground or polished), with a surface condition of 96 wt% purity containing sintering aid glass forming additives to allow liquid phase sintering of ceramic layer 105 at reduced temperature compared to not having glass forming additives. Aluminum oxide with 96 wt% purity contains approximately 5 vol.% of voids and free space and exhibits surface roughness of approximately 0.40 microns Ra. It is this voiding and free space that provides the pathway for corrosion growth. The advancements discussed below with respect to FIGS. 3 - 12 reduce the available pathway by limiting the voiding and free space.

Metal 120 (including metal portion 120a and metal portion 120b) are bonded to ceramic layer 105 using bond 135c. Bond 135c represents any bonding used to join metal 120 to ceramic layer 105. For example, metal 120 may be joined to ceramic layer 105 using direct bonding, active brazing, regular brazing, direct aluminum bonding, direct copper bonding, or the like. Metal 120 may be joined to ceramic layer 105 as a complete sheet of metal and etched using chemical etching to form trench 115. For example, a pattern may be developed using a photoresist material, which may be washed away during a cleaning step to expose only the metal to be removed. Then, the metal intended to be removed may be exposed to an acidic or alkaline etching solution until all of the metal is removed within the pattern down to ceramic layer 105. Metal 120 may be, for example, oxygen-free high conductivity copper, aluminum, or a metal alloy. Metal 120a and metal 120b may be plated with a non-oxidizing material in some embodiments. For example, metal 120a and metal 120b may be nickel-plated or gold-plated. Once etched, metallic layer 110 includes all remaining metal 120 and trench 115 separating the portions of metal 120, including metal 120a and metal 120b. Trench 115 extends the depth of metal 120b to expose the surface of ceramic layer 105. Trench 115 is an insulating trench intended to provide electrical insulation between metal 120a and metal 120b. In use, metal 120a and metal 120b often have a voltage difference. For example, the voltage of metal 120a may be many volts greater or less than the voltage of metal 120b based on the circuitry design within power electronic module 100.

Metal-ceramic substrate 165 is depicted as including metallic layer 110, bond 135c that bonds metallic layer 110 to ceramic layer 150, and ceramic layer 105. In common parlance, metal 140, baseplate 125, and bonds 135a and 135b are included in metal-ceramic substrate 165. However, baseplate 125, metal 140, and bonds 135a and 135b are not included in the discussions of metal-ceramic substrate 165 throughout this disclosure because they may be any formation, materials, and configuration that differ from the example depicted here without impacting the spirit and scope of the present disclosure. In other words, the details of baseplate 125, metal 140, and bonds 135a and 135b may be different than those depicted here and there may be additional or fewer layers within power electronic module 100 below ceramic layer 105 without departing from the spirit and scope of this disclosure.

Bond 135d may represent any bonding used to join terminals 155 and chips 145 to metal 120. For example, bond 135d may be any bonding material, adhesive, or solder used to join terminals 155 and chip 145 to metal 120. In some embodiments, different types of bonding may be used for bond 135d between terminals 155 and metal 120 than is used for bond 135d between chip 145 and metal 120.

Chip 145 may be any semiconductor chip used to create the desired circuitry within power electronic module 100. While a single chip 145 is shown as exemplary, many chips 145 may be included in power electronic module 100. Wire 150 represents any connection wire or bonding wire used to electrically couple relevant elements or portions of chip 145 to metal 120b. Wire 150 is representative of any wires electrically coupling semiconductor chips or other terminals to other conductive areas within power electronic module 100. Terminals 155a and 155b represent terminals exposed outside of housing 130 used to connect power electronic module 100 to a larger system as input, output, power connections, or the like. There may be more or fewer terminals 155 in power electronic module 100.

Housing 130 may be a plastic housing joined to baseplate 125 that encloses metal 140, ceramic layer 105, metal 120, chip 145, and wire 150 within power electronic module 100. Housing 130 may be perforated or otherwise not airtight in some embodiments. Within housing 130 is encapsulation area 160. In some embodiments, encapsulation area 160 is filled or partially filled with an encapsulation material (e.g., silicone-based potting material) that covers and surrounds metal 140, ceramic layer 105, metal 120, chip 145, and wire 150. The encapsulation material may bond to the exposed elements within encapsulation area 160. For example, the encapsulation material may bond to the surface of ceramic layer 105 within trench 115.

During manufacturing of power electronic module 100, the metal-ceramic substrate 165 may be assembled before bonding chip 145 and terminals 155 to metal-ceramic substrate 165. The techniques discussed below may be performed once trench 115 is formed but before chip 145 and terminals 155 are bonded to metal 120.

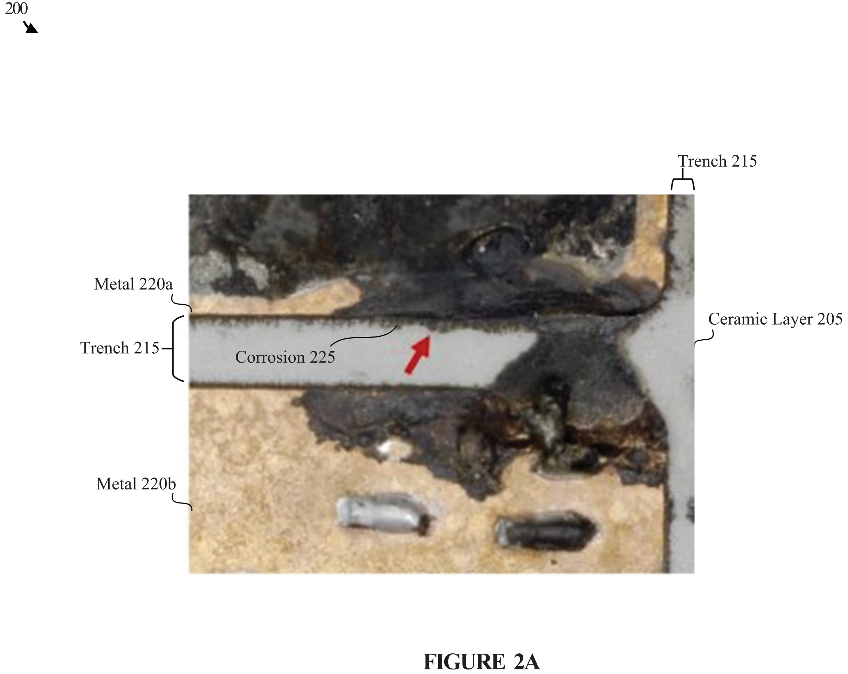

**FIG.** 2A illustrates an exemplary image 200 depicting a top-down view of a portion of a power electronic module, such as power electronic module 100, that is experiencing corrosion growth. Image 200 includes metal 220a, metal 220b, trench 215, ceramic layer 205, and corrosion 225. Metal 220a and 220b may be substantially the same as metal 120 described with respect to FIG. 1. Trench 215 may be substantially the same as trench 115 described with respect to FIG. 1. Ceramic layer 205 may be substantially the same as ceramic layer 105 described with respect to FIG. 1. In the top-down view of image 200, the exposed portion of ceramic layer 205 is seen through the metallic layer (e.g., metallic layer 110) where trench 215 is present. Corrosion 225 extends from metal 220a and metal 220b across trench 215 via at least the surface layer of ceramic layer 205. The voltage potential difference between metal 220a and metal 220b provides encouragement for corrosion 225 to grow through the pathways of the surface layer of ceramic layer 205 due to the voids and free space due to the roughness of ceramic layer 205. This corrosion 225, when it extends some or all of the distance across trench 215, electrically couples metal 220a to metal 220b, reducing or eliminating the electrical isolation benefit of trench 215. Accordingly, the power electronic module may experience unwanted electrical behavior including overheating, shorting, arcing, and the like. This behavior may represent a physical danger to nearby people or equipment or may cause internal damage to the equipment.

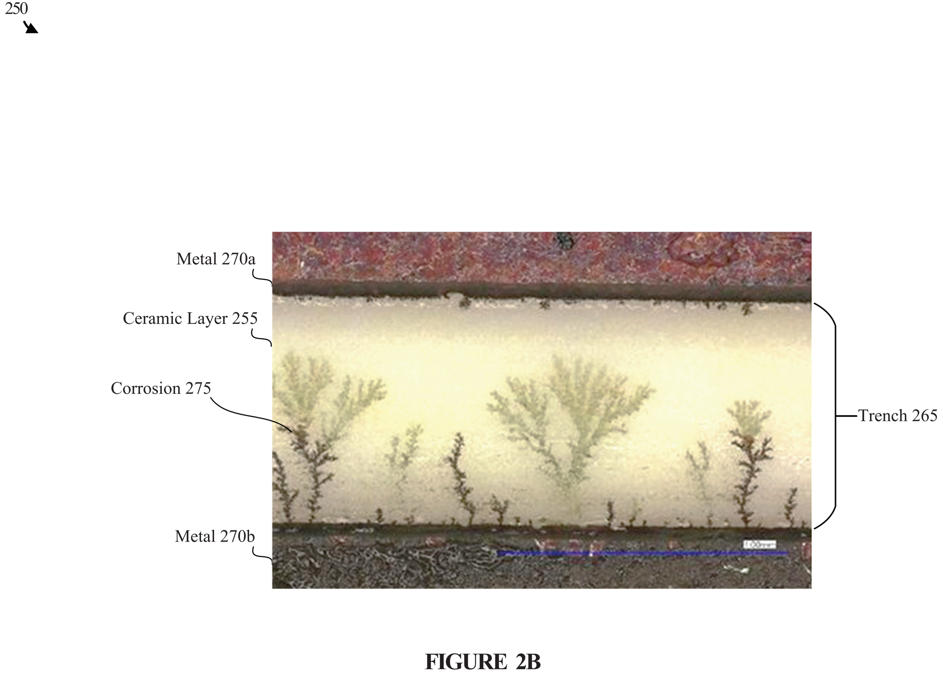

**FIG. 2B** illustrates an exemplary image 250 depicting a magnified top-down view of a portion of a power electronic module, such as power electronic module 100, that is experiencing corrosion growth. Image 250 is similar to image 200, though it is magnified substantially to show the tree-like corrosion growth. Image 250 includes metal 270a, ceramic layer 255, metal 270b, trench 265, and corrosion 275. Metal 270a and 270b may be substantially the same as metal 120 described with respect to FIG. 1 and metal 220a and metal 220b described with respect to FIG. 2A. Trench 265 may be substantially the same as trench 115 described with respect to FIG. 1 and trench 215 described with respect to FIG. 2A. Ceramic layer 255 may be substantially the same as ceramic layer 105 described with respect to FIG. 1 and ceramic layer 205 described with respect to FIG. 2A. In image 250, the exposed portion of ceramic layer 255 is seen through the metallic layer (e.g., metallic layer 110) where trench 265 is present. Corrosion 275 extends from metal 270b across trench 265 via at least the surface layer of ceramic layer 255. Corrosion 275 is substantially the same as corrosion 225, so when it extends some or all of the distance across trench 265, the same shorting, damage, and danger issues arise.

FIG. 3 illustrates a cross-sectional view of a portion of modified metal-ceramic substrate 300 designed to limit or eliminate the corrosion issues described above and shown in FIGS. 2A and 2B. Modified metal-ceramic substrate 300 includes metallic layer 310 bonded via bond 335 to ceramic layer 305. Where metal 320 is removed (e.g., using etching) from metallic layer 310 to form portions of metal 320 including metal 320a and metal 320b, ceramic layer 305 is exposed within trench 315. Portions of the surface layer of ceramic layer 305 are modified within trench 315, depicted as modified region 325. Specifically, modified region 325 represents a smoother surface with less voids and free space within trench 315 than if the surface layer of ceramic layer 305 is not modified.

Ceramic layer 305 may be a sheet of a ceramic-containing material. For example, ceramic layer 305 may be aluminum oxide, aluminum nitride, silicon nitride, zirconia toughened aluminum oxide, or beryllium oxide. Ceramic layer 305 may be formed with various purities including, for example, 90 wt%, 96 wt%, 98 wt%, or 99 wt% purity. Prior to modification to add modified region 325, ceramic layer 305 may be substantially the same as ceramic layer 105 as described with respect to FIG. 1. However, ceramic layer 305, modified as described herein, includes improvements over ceramic layer 105. Accordingly, ceramic layer 305 may be improved with modified region 325. Ceramic layer 305 may be any thickness, such as for example 0.020 inches to 0.06 inches.

Metal 320 may be bonded to ceramic layer 305 using bond 335. Metal 320 may be any suitable electrically conductive material, for example, copper, aluminum, or a metal alloy. Metal 320 may be any thickness, such as for example 0.010 inches to 0.020 inches. Bond 335 may represent any suitable bonding such as for example active brazing, regular brazing, direct bonding, and the like. Any suitable form of generating the desired electrical regions of metal 320a and metal 320b may be used, and the separations between them form trench 315. For example, metal 320 may be patterned and etched as discussed above to separate portions of metal 320a from metal 320b by trench 315. Metal 320a and metal 320b may be plated with a non-oxidizing material in some embodiments. For example, metal 320a and metal 320b may be nickel-plated or gold-plated. Trench 315 is an electrically insulating region between metal 320a and metal 320b.

Modified region 325 may be created as a step during manufacture of modified metal-ceramic substrate 300 once trench 315 is formed. In some embodiments, modified region 325 may be added before final steps including cleaning and sectioning. Modified region 325 represents modifying the surface layer of ceramic layer 305 within trench 315 to smooth the surface layer. For example, melting and resolidifying the modified region 325 results in a smoother surface having a lower surface roughness value than other surfaces of ceramic layer 305. To create modified region 325, the exposed surface of ceramic layer 305 in trench 315 may be melted. In some embodiments, modified region 325 may extend the entire length and width of the surface exposed by trench 315. In some embodiments, only a portion of the total exposed ceramic surface, such as a track down the center of trench 315 is modified. In tests, a pulsed laser of 1064nm wavelength was used having a 10W maximum power, 39A output, and 10 - 40 KHz pulse frequency. Traverse speed of 100 mm/s was used. However, specific values and lasers may vary based on the type of laser, the type of material used for ceramic layer 305, and so forth. For example, carbon dioxide (CO₂) lasers may be used as they may be less likely to react with metal 320 if accidental contact occurs with the laser beam. An ultraviolet (UV) excimer laser may also be used. The depth of modified region 325 (e.g., the laser beam track, the melted surface layer) may be shallow relative to the overall thickness of ceramic layer 305. For example, the thickness of modified region 325 may be 1% - 5% of the thickness of ceramic layer 305. The depth of modified region 325 should be small enough to avoid cracking ceramic layer 305 during modification or later during power cycling of the power electronic module while in use. Using a laser, the laser beam track applied within trench 315 should melt by transformation of absorbed laser energy into thermal energy and resolidified upon removal of the laser beam after the surface has cooled. The result is densification and smoothing of modified region 325. This smoothing of the surface topography reduces surface voids in modified region 325 where moisture and dissolved corrosive gas contaminants would otherwise collect, creating corrosion. Accordingly, modified region 325 provides high resistance against electrical charged ion movement in the presence of applied voltage across trench 315, contaminant gases, and humidity. In addition to using a laser to apply directed energy to create modified region 325, other techniques may be used to melt or modify modified region 325 to result in the smoothing effect shown with laser applied directed energy. For example, melting or modification can be performed by applying chemicals to create a thermos-chemical reaction or precision directed ultrasonic energy may be used. One advantage of using lasers is that they are regularly used for other steps of power electronic module manufacturing, so adjustments may be easily applied.

Modifying the surface layer of trenches such as by adding modified region 325 may independently thwart the growth of corrosion. However, additional protection may be obtained, in some embodiments, by sealing the housing (e.g., housing 130) of the power electronic module into which the metal ceramic substrate 300 is encased. An air and gas-tight seal may be used to further reduce corrosion within the power electronic module.

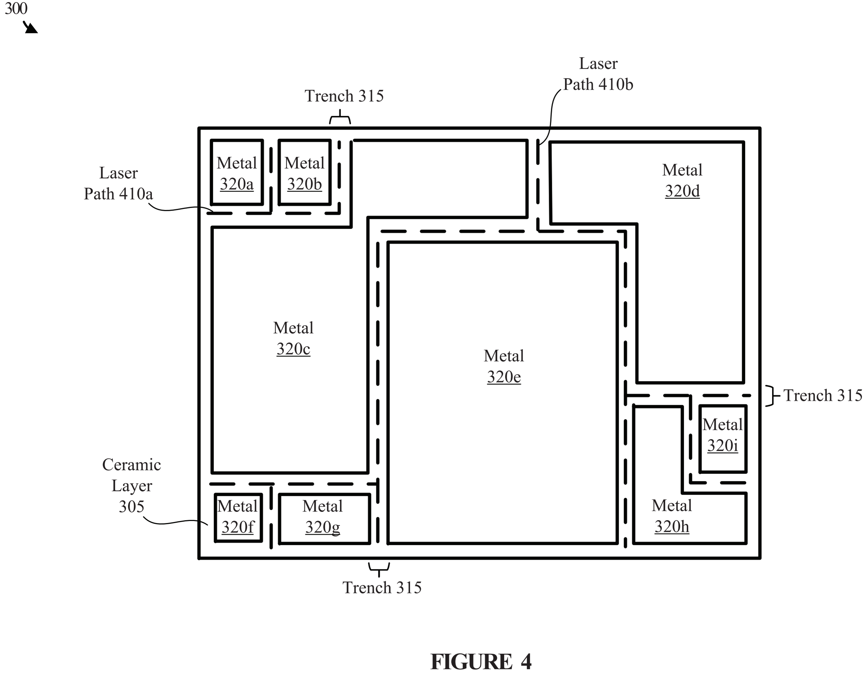

FIG. 4 illustrates a top-down view of modified metal-ceramic substrate 300 having a laser path 410 for adding modified region 325 to trench 315. Laser path 410a, 410b (collectively laser path 410) shows that modified region 325 may be added to all portions of trench 315. In some embodiments, not all portions of trench 315 are modified by laser path 410. Trench 315 may be formed using etching, as described above, to separate metal 320 into portions including metal 320a, 320b, 320c, 320d, 320e, 320f, 320g, 320h, 320i. The particular configuration of the portions of metal 320 are exemplary only.

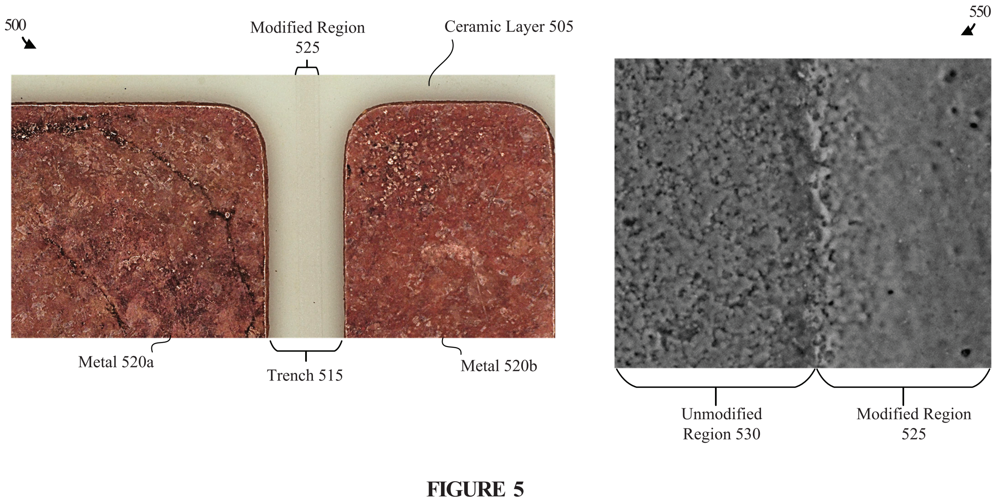

FIG. 5 illustrates a top-down view of a portion of a metal-ceramic substrate (e.g., metal-ceramic substrate 300) in image 500 as well as a magnified view of the modifications in image 550. Image 500 includes metal 520a, metal 520b, ceramic layer 505, trench 515, and modified region 525. Metal 520a may be substantially the same as metal 320a, metal 520b may be substantially the same as metal 520b, trench 515 may be substantially the same as trench 315, ceramic layer 505 may be substantially the same as ceramic layer 305, and modified region 525 may be substantially the same as modified region 325. In image 500, modified region 525 was created using a laser. It is somewhat difficult to see the distinction of modified region 525 from unmodified portions of the surface of ceramic layer 505. However, note that modified region 525 extends the length of trench 515, but it does not extend the entire width of trench 515 between metal 520a and metal 520b. Rather, a centerline laser beam track was used. In testing scenarios, melting a portion of the width of trench 515 provided 2.5 - 3 times improvement in corrosion resistance.

Image 550 shows a magnified view of modified region 525 compared to unmodified region 530 within trench 515. In image 500, all surfaces exposed in trench 515 are unmodified except modified region 525. Image 550 illustrates the improved density and reduced surface voids in modified region 525 as compared to unmodified region 530.

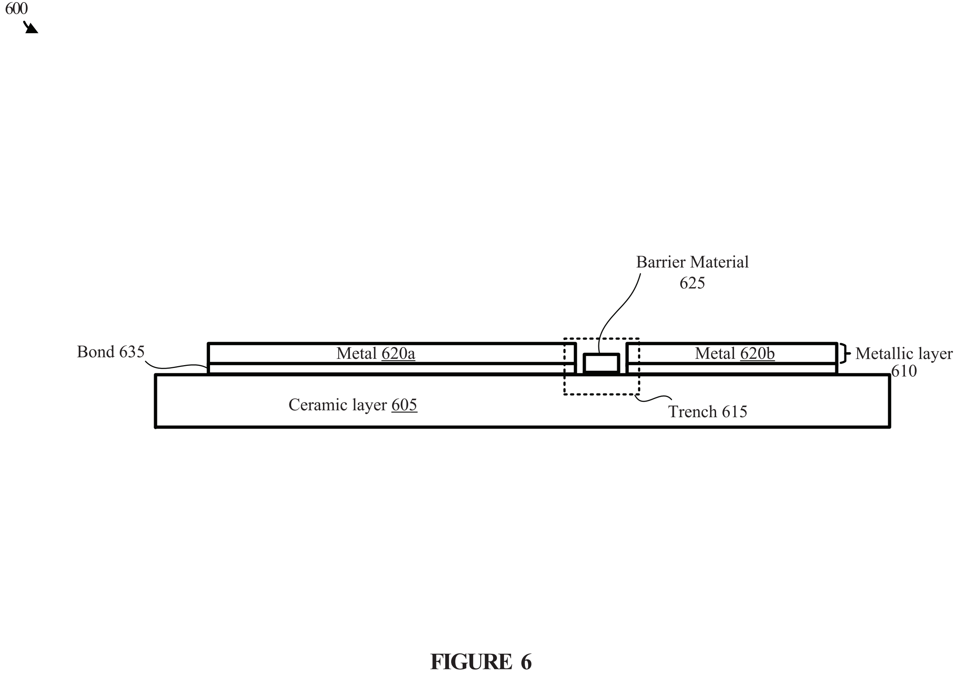

**FIG.** 6 illustrates a cross-sectional view of a portion of modified metal-ceramic substrate 600 designed to limit or eliminate the corrosion issues described above and shown in FIGS. 2A and 2B. Modified metal-ceramic substrate 600 includes metallic layer 610 bonded via bond 635 to ceramic layer 605. Where metal 620 is removed (e.g., using etching) from metallic layer 610 to form portions of metal 620 including metal 620a and metal 620b, ceramic layer 605 is exposed within trench 615. Barrier material 625 is disposed on the surface of ceramic layer 605 within trench 615. Barrier material 625 represents a smoother surface with less voids and free space within trench 615 than if the surface layer of ceramic layer 305 is exposed and barrier material 625 is not included.

Ceramic layer 605 may be a sheet of a ceramic-containing material. For example, ceramic layer 605 may be aluminum oxide, aluminum nitride, silicon nitride, zirconia toughened aluminum oxide, or beryllium oxide. Ceramic layer 605 may be formed with various purities including, for example, 90 wt%, 96 wt%, 98 wt%, or 99 wt% purity. Ceramic layer 605 may be substantially the same as ceramic layer 105 as described with respect to FIG. 1. Ceramic layer 605 may be any thickness, such as for example 0.020 inches to 0.06 inches.

Metal 620 may be bonded to ceramic layer 605 using bond 635. Metal 620 may be any suitable electrically conductive material, for example, copper, aluminum, or a metal alloy. Metal 620 may be any thickness, such as for example 0.010 inches to 0.020 inches. Bond 335 may represent any suitable bonding such as for example active brazing, regular brazing, direct bonding, and the like. Any suitable form of generating the desired electrical regions of metal 620a and metal 620b may be used, and the separations between them form trench 615. For example, metal 620 may be patterned and etched as discussed above to separate portions of metal 620a from metal 620b by trench 615. Metal 620a and metal 620b may be plated with a non-oxidizing material in some embodiments. For example, metal 620a and metal 620b may be nickel-plated or gold-plated. Trench 615 is an electrically insulating region between metal 620a and metal 620b.

Barrier material 625 is placed within trench 615 and bonded on the surface of ceramic layer 605. Barrier material 625 may fill any space within trench 615 such that it does not physically contact (i.e., touch) the walls of trench 615. In other words, barrier material 625 does not touch metal 620a or metal 620b. Barrier material 625 may be added to modified metal-ceramic substrate 600 as a step during manufacture of modified metal-ceramic substrate 600 once trench 615 is formed. In some embodiments, barrier material 625 may be added after metal 620a and metal 620b are plated and before final steps including cleaning and sectioning of metal-ceramic substrate 600. In some embodiments, where metal 620a and metal 620b are not plated as part of the manufacturing process with, for example, 100 to 400 microinches of plating, a thin layer (i.e., greater than approximately 50 microinches and less than approximately 100 microinches) of non-oxidizing plating material (e.g., nickel, gold, noble metal, or the like) may be added at least to the edges of metal 620a and metal 620b (i.e., the walls of trench 615). After adding the plating material, metal-ceramic substrate 600 may be washed to remove residual plating chemicals before placing barrier material 625 within trench 615.

Barrier material 625 may be applied, for example, as a paste or powder within trench 615. Barrier material 625 may be applied, for example, by a precision automated dispenser, swept into trench 615, or the like. Barrier material 625 may be an electrically insulating material that, when heated to a flow point, cools into a hardened material that has a smoother surface with less voids than the surface of ceramic layer 605. For example, barrier material 625 may be a glass-containing material such as a lead-free bismuth zinc borate-based low temperature sealing glass. Other glass materials that may be included in barrier material 625 include, for example, bismuth borate glasses, lead borate glasses, borosilicate glasses, or phosphate glasses. Barrier material 625 may include glass materials having low alkali content. For glass-containing materials, the glass composition and heating temperature may be chosen so that the glass surface tension draws the glass melt inward toward itself, avoiding bonding and covering the walls of trench 615. Once cooled, barrier material 625 does not contact the walls of trench 615, which avoids cracking of barrier material 625 and other unfavorable outcomes. In some embodiments, a polyvinyl butyral or terpinol may be used as a binder base material to encourage barrier material 625 to bond to the surface of ceramic layer 605. Barrier material 625, once cooled may have any suitable height. For example, barrier material 625 may be between 25% and 100% the height (i.e., thickness) of metal 620. Cooling may be done naturally by removing the heat source (e.g., removing modified metal-ceramic substrate 600 from a heating oven) and allowing barrier material 625 to cool slowly to an ambient temperature to avoid cracking barrier material 625. The flow or melting point of barrier material 625 is less than the melting temperature of metal 620, any plating material used, and ceramic layer 605 such that when heated, the temperature may be set (e.g., in an oven) to a point above the flow point of barrier material 625 and below the melting temperature of metal 620, ceramic layer 605, and any plating material. Barrier material 625 may be selected to have a coefficient of thermal expansion that is similar to or the same as the coefficient of thermal expansion of ceramic layer 605 to further avoid cracking barrier material 625 during cooling.

In some embodiments, barrier material 625 may be a polymer resin rather than a glass-containing material. For example, barrier material 625 may be an epoxy, parylene, or polyimide material. In such embodiments, the resin may be deposited along a centerline of trench 615 and may not need heating before allowing the resin to set (i.e., harden).

Using barrier material such as barrier material 625 may independently thwart the growth of corrosion. However, additional protection may be obtained, in some embodiments, by sealing the housing (e.g., housing 130) of the power electronic module into which the metal ceramic substrate 600 is encased. An air and gas-tight seal may be used to further reduce corrosion within the power electronic module.

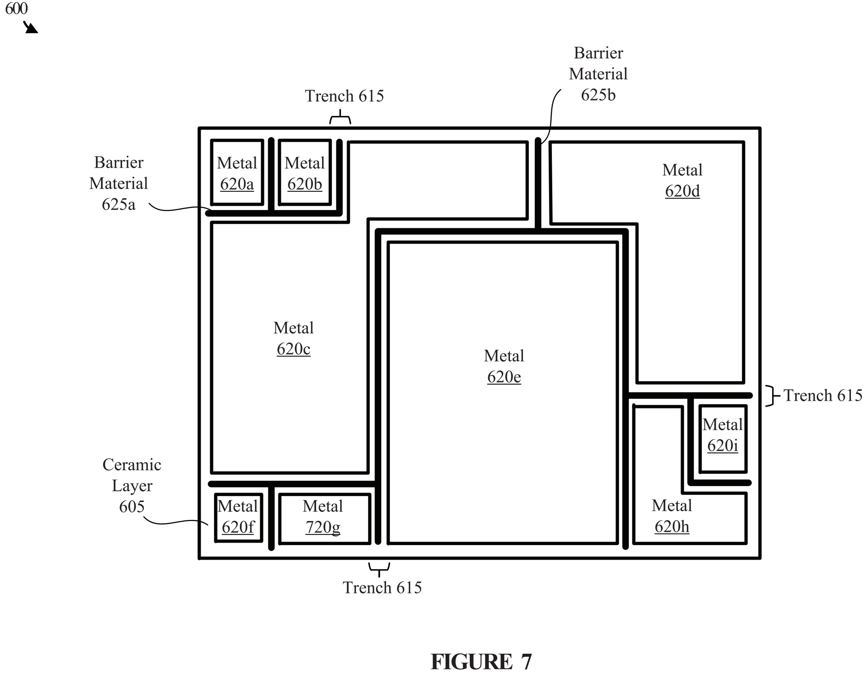

**FIG. 7** illustrates a top-down view of modified metal-ceramic substrate 600 having barrier material 625 added to trench 615. Barrier material 625a and barrier material 625b (collectively barrier material 625) shows that barrier material 625 may be added to all portions of trench 615. Further, barrier material 625 does not physically touch any portion of metal 620. In some embodiments, not all portions of trench 615 include barrier material 625. Trench 615 may be formed using etching, as described above, to separate metal 620 into portions including metal 620a, 620b, 620c, 620d, 620e, 620f, 620g, 620h, 620i. The particular configuration of the portions of metal 620 are exemplary only.

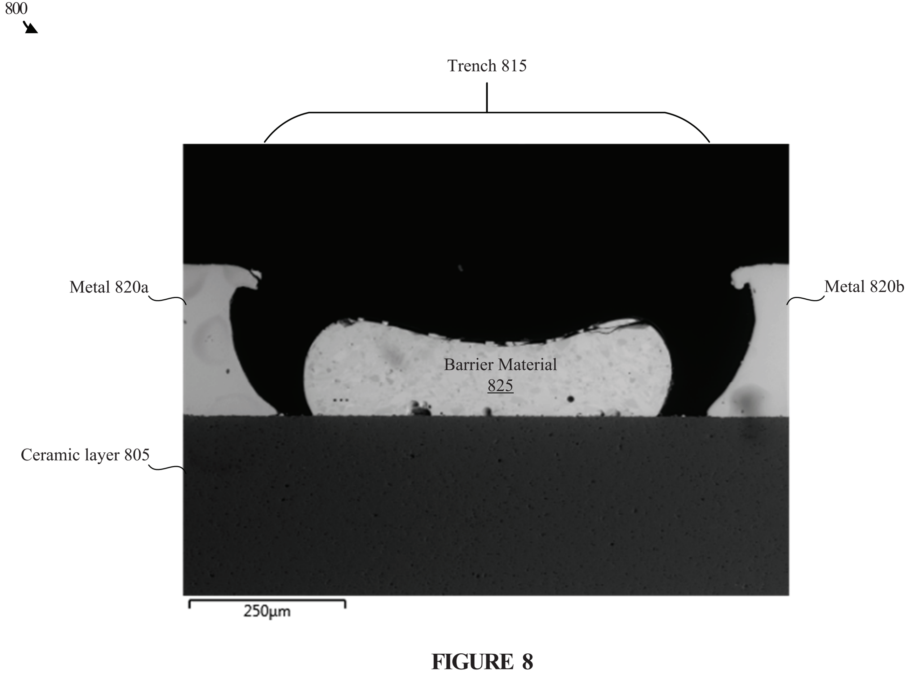

**FIG. 8** illustrates an image 800 of a magnified cross-sectional view of a portion of a modified metal-ceramic substrate such as modified metal-ceramic substrate 600 having a barrier fill material 825. Image 800 includes ceramic layer 805, metal 820a, metal 820b, trench 815, and barrier material 825. Metal 820a may be substantially the same as metal 620a, metal 820b may be substantially the same as metal 620b, trench 815 may be substantially the same as trench 615, ceramic layer 805 may be substantially the same as ceramic layer 605, and barrier material 825 may be substantially the same as barrier material 625. As seen in image 800, barrier material 825 does not contact metal 820a or 820b. Barrier material 825 has a thickness that is larger at the edges than in the middle, which may happen in some embodiments. In some embodiments, barrier material 825 may form a more rounded or flat shape at the top depending on the amount of barrier material 825 placed within trench 815, the type of material used for barrier material 825, the temperature at which barrier material 825 is heated, and so forth. Barrier material 825 reduces or eliminates corrosion extending between metal 820a and metal 820b in part due to the smoother surface of barrier material 825 than the surface of ceramic layer 805 and possibly in part due to the further distance and directional changes corrosion would have to travel, for example, from metal 820a, across the surface of ceramic layer 805 still exposed to the edge of barrier material 825, up and over and down the surface of barrier material 825, and across the other exposed surface of ceramic layer 805 to reach metal 820b. In tests, corrosion did not occur even given 10 times the amount of time for corrosion to occur on an unmodified metal-ceramic substrate such as metal-ceramic substrate 100.

Image 800 illustrates trench 815 being approximately 700 microns wide, and barrier material 825 being approximately 550 microns wide with barrier material 825 being substantially centered within the width of trench 815. Trench 815 may be any width, though 700 microns is representative of typical widths of trenches in power electronic modules such as trenches 115, 315, 615 in power electronic modules 100, 300, 600, respectively. Barrier material 825 may be any width in various embodiments including a percentage of the width of trench 815 such as, for example, 25% to 80% the width of trench 815.

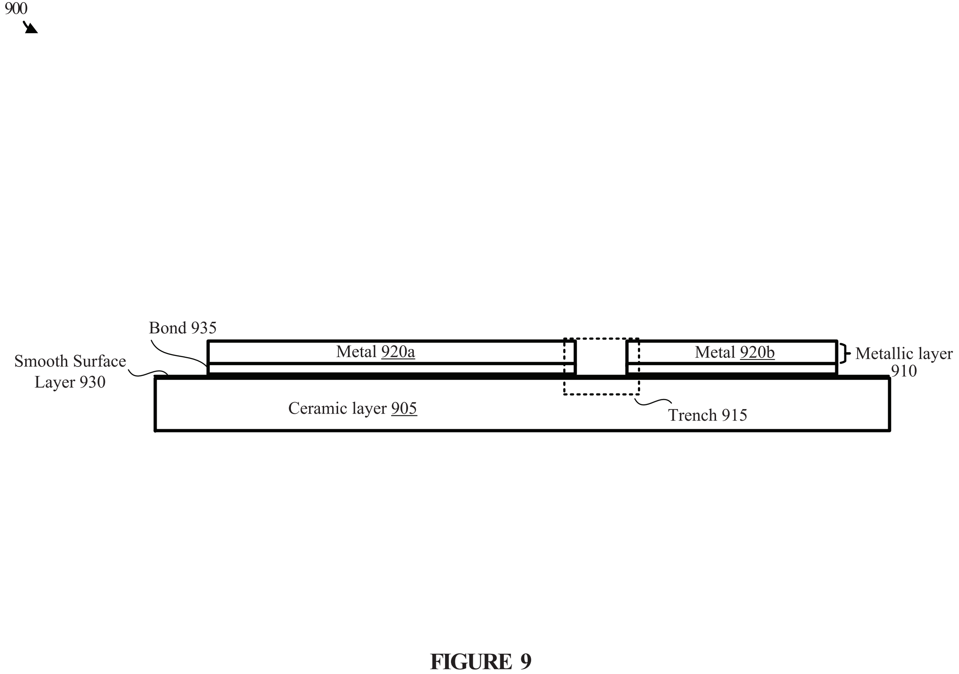

**FIG. 9** illustrates a cross-sectional view of a portion of improved metal-ceramic substrate 900 designed to limit or eliminate the corrosion issues described above and shown in FIGS. 2A and 2B. Improved metal-ceramic substrate 900 includes metallic layer 910 bonded via bond 935 to ceramic layer 905. Where metal 920 is removed (e.g., using etching) from metallic layer 910 to form portions of metal 920 including metal 920a and metal 920b, ceramic layer 905 is exposed within trench 915. Ceramic layer 905 includes a smooth surface layer 930, which represents a smoother surface with less voids and free space within trench 915 than if the surface layer of ceramic layer 905 is not smoothed.

Ceramic layer 905 may be a sheet of a ceramic-containing material. For example, ceramic layer 905 may be aluminum oxide, aluminum nitride, silicon nitride, zirconia toughened aluminum oxide, or beryllium oxide. Ceramic layer 905 may be formed with various purities including, for example, 90 wt%, 96 wt%, 98 wt%, or 99 wt% purity. Ceramic layer 905 may be any thickness, such as for example 0.020 inches to 0.06 inches. To ensure ceramic layer 905 is high density and/or ultra-low roughness such that it includes smooth surface layer 930, various techniques can be used. For example, small particle materials (e.g., particle size of the ceramic powder) can be used to form ceramic layer 905. As another example, higher purity ceramic material can be used to form ceramic layer 905. As yet another example, pressure can be used to form and condense the material during creation of ceramic layer 905. Another example includes that once formed, ceramic layer 905 may be smoothed by, for example, polishing, sanding, or grinding the surface of ceramic layer 905 to form smooth surface layer 930. Any one or combination of these techniques may be used to ensure the surface roughness of smooth surface layer 930 of ceramic layer 905 may be less than or equal to no more than 0.25 microns Ra, 0.20 microns Ra, 0.15 microns Ra, or 0.10 microns Ra. The lower the surface roughness value, the better corrosion resistance is obtained. Accordingly, surface roughness of smooth surface layer 930 may be less than or equal to 0.10 microns Ra, 0.08 microns Ra, 0.06 microns Ra, or 0.05 microns Ra. Further, void or free space density of smooth surface layer may be less than 8 vol.%, 7 vol.%, 5 vol.%, or 3 vol.%. In some embodiments, both sides of ceramic layer 905 are similarly smoothed such that both sides of ceramic layer 905 are smooth surface layers 930.

Metal 920 may be bonded to ceramic layer 905 using bond 935. Metal 920 may be any suitable electrically conductive material, for example, copper, aluminum, or a metal alloy. Metal 920 may be any thickness, such as for example 0.010 inches to 0.020 inches. Bond 935 may represent any suitable bonding such as for example active brazing, regular brazing, direct bonding, and the like. Any suitable form of generating the desired electrical regions of metal 920a and metal 920b may be used, and the separations between them form trench 915. For example, metal 920 may be patterned and etched as discussed above to separate portions of metal 920a from metal 920b by trench 915. Metal 920a and metal 920b may be plated with a non-oxidizing material in some embodiments. For example, metal 920a and metal 920b may be nickel-plated or gold-plated. Trench 915 is an electrically insulating region between metal 920a and metal 920b.

When ceramic layer 905 includes smooth surface layer 930 prior to assembly (i.e., ceramic layer 905 is high density and/or ultra-low roughness), the exposed portions of ceramic layer 905 within trench 915 are smoother and with fewer voids than unsmoothed ceramic layers such as ceramic layer 105. Accordingly, corrosion is hindered because the pathways across ceramic layer 905 between metal 920a and metal 920b are limited.

Using a polished or otherwise smooth surface ceramic layer such as ceramic layer 905 may independently thwart the growth of corrosion. However, additional protection may be obtained, in some embodiments, by further sealing the housing (e.g., housing 130) of the power electronic module into which the metal ceramic substrate 900 is encased. An air and gas-tight seal may be used to further reduce corrosion within the power electronic module.

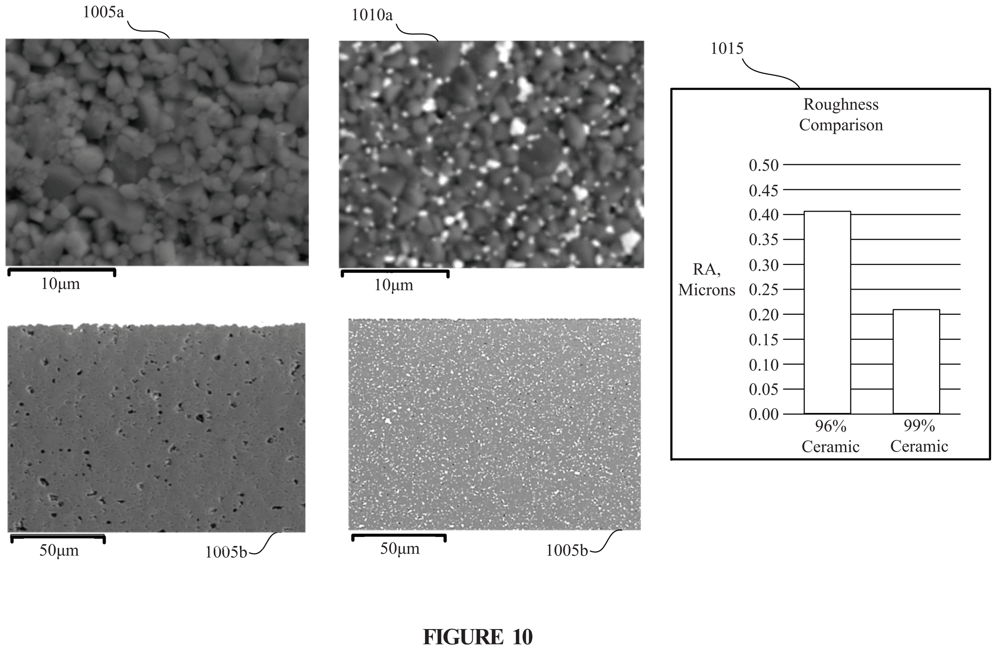

**FIG. 10** illustrates distinctions between a high density low roughness ceramic layer (e.g., ceramic layer 905) and a typical ceramic layer (e.g., ceramic layer 105). Image 1005a is a magnified depiction of a surface of a ceramic layer (e.g., ceramic layer 105) having 96% purity in an "as fired" state. Image 1005b is a less magnified depiction of the surface of the same ceramic layer depicted in image 1005a. As shown, there are substantial voids. Graph 1015 shows a roughness comparison, indicating that the surface roughness of the ceramic layer depicted in images 1005a and 1005b is approximately 0.40 microns Ra.

Image 1010a is a magnified depiction of a surface of a high density low roughness ceramic layer (e.g., ceramic layer 905) having 99% purity and having been polished using a polishing technique such as sanding. In some embodiments, ceramic layer 905 may be polished further to reduce the surface roughness value beyond that depicted in images 1010a and 1010b. The amount of polishing and the technique used may impact the surface roughness value. Image 1010b is a less magnified depiction of the surface of the same ceramic layer depicted in image 1010a. As shown, there are not substantial voids, and those existing voids are much smaller than those in the ceramic layer depicted in images 1005a and 1005b. Further, the particle size of the material making up the ceramic layer depicted in image 1005a is much larger than the particle size of the material making up the ceramic layer depicted in image 1010a. Graph 1015 indicates that the surface roughness of the ceramic layer depicted in images 1010a and 1010b is approximately 0.20 microns Ra. As discussed above, further polishing, pressure during formation, higher purity, and/or smaller particles used for forming the ceramic layer may be used in any combination to further reduce the surface roughness value of less than 0.15 microns Ra and even to 0.10 microns Ra or less. The smoother the surface of the ceramic layer, the less vulnerable to corrosion the power electronic module is. In a preferred embodiment, the smooth surface of the ceramic layer may be less than 0.10 microns Ra surface roughness and less than 5 vol.% voids.

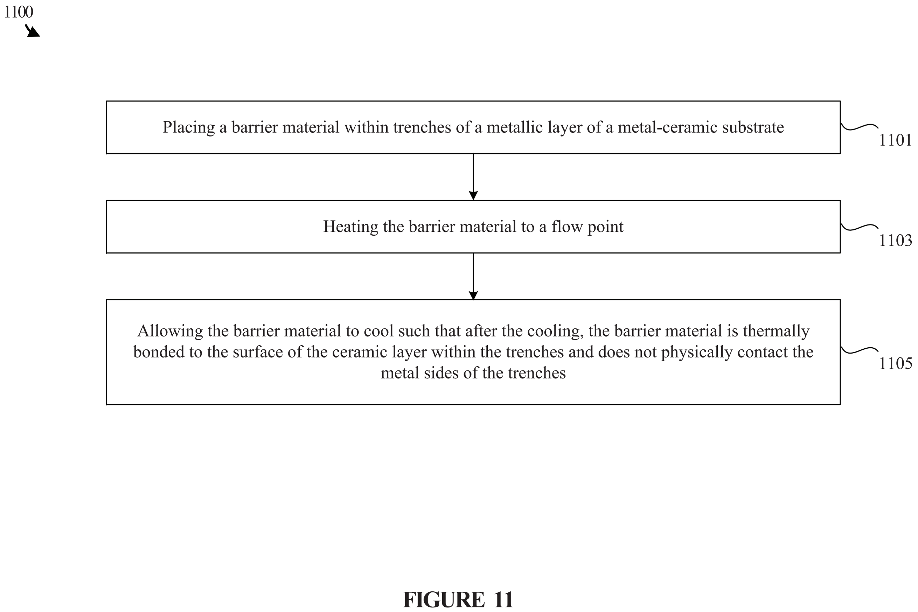

**FIG. 11** illustrates a method 1100 for creating a metal-ceramic substrate (e.g., metal-ceramic substrate 600, 800) with a barrier material (e.g., barrier material 625, 825). Method 1100 includes step 1101 with placing a barrier material within trenches of a metallic layer of a metal-ceramic substrate. For example, during assembly of the metal-ceramic substrate (e.g., metal-ceramic substrate 600, 800), a metal sheet (e.g., metal 620, 820) may be bonded to the ceramic layer (e.g., ceramic layer 605, 805). The metal sheet may be patterned and etched to form trenches (e.g., trenches 615, 815) between portions of the metal (e.g., metal 620a, 820a and metal 620b, 820b). The portions of the metal (e.g., metal 620a, 820a and metal 620b, 820b) may be plated or the walls of the trenches (e.g., edges of the metal forming the trenches 615, 815) may be plated with a non-oxidizing material such as nickel or gold. After cleaning away residue, the barrier material (e.g., barrier material 625, 825) may be placed along, for example, a centerline of the trench (e.g., trench 615, 815). The barrier material may be a glass-containing material, a glass-ceramic material, a polymeric material, or a combination thereof. Based on the type of material, the barrier material may be precisely placed or not precisely placed (e.g., swept) into the trench (e.g., trench 615, 815).

At step 1103, the barrier material is heated to a flow point. For example, a glass-containing material may be heated to melt. A polymer material (e.g., polymer resin, epoxy, or the like) may or may not require heating to allow the polymer to properly bond to the ceramic layer (e.g., ceramic layer 605, 805). For example, the polymer material may include a chemical that forms a chemical or thermo-chemical bond between the polymer and the ceramic layer.

At step 1105, the barrier material is allowed to cool such that after cooling, the barrier material is bonded to the surface of the ceramic layer within the trenches and does not physically contact the walls of the trench (e.g., metal edges). To cool the barrier material (e.g., barrier material 615, 815), the heat source is removed, and the barrier material may gradually cool to an ambient temperature. In some embodiments, reducing the heat below ambient temperature (e.g., refrigeration) may be used to cool the barrier material, but the risk of cracking the barrier material is increased.

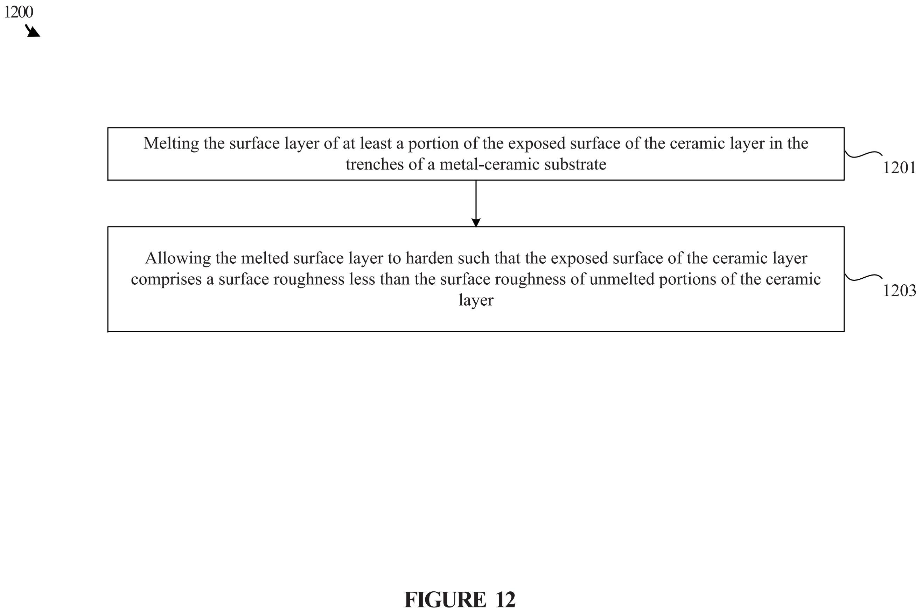

**FIG. 12** illustrates a method 1200 for modifying a metal-ceramic substrate (e.g., modified metal-ceramic substrate 300) by smoothing at least some of the exposed surface layer of the ceramic layer (e.g., ceramic layer 305) within the trenches (e.g., trench 315). Method 1200 includes step 1201 with melting the surface layer of at least a portion of the exposed surface of the ceramic layer in the trenches of a metal-ceramic substrate. For example, during assembly of the metal-ceramic substrate (e.g., metal-ceramic substrate 300), a metal sheet (e.g., metal 320, 520) may be bonded to the ceramic layer (e.g., ceramic layer 305, 505). The metal sheet may be patterned and etched to form trenches (e.g., trenches 315, 515) between portions of the metal (e.g., metal 320a, 520a and metal 320b, 520b). A laser path (e.g., laser path 415) may be used by a laser to melt a portion of the surface layer of the ceramic layer (e.g., ceramic layer 305, 505) to create a modified region (e.g., modified region 325, 525). In some embodiments, a chemical disposed along a centerline (e.g., laser path 410) may melt the surface layer of the ceramic layer.

At step 1203, the melted surface layer is allowed to cool and harden such that the exposed surface of the ceramic layer includes a surface roughness less than the surface roughness of unmelted portions of the ceramic layer. For example, modified region 525 is smoother and has a surface roughness less than unmodified region 530 as shown and described with respect to FIG. 5.

### Exemplary method embodiments:

A method, comprising: applying a barrier material within trenches of a metallic layer of a metal-ceramic substrate, wherein: the metal-ceramic substrate comprises: a ceramic layer; and the metallic layer, comprising: a metal joined to a surface of the ceramic layer, and trenches separating portions of the metal through which portions of the surface of the ceramic layer is exposed, the applying comprises: placing the barrier material within the trenches; heating the barrier material to a flow point; and allowing the barrier material to cool, after cooling, the barrier material is thermally bonded to at least a portion of the surface of the ceramic layer exposed within the trenches, and after cooling, the barrier material does not physically contact the portions of the metal separated by the trenches.

The method, wherein the barrier material is one of a glass, a glass-ceramic, and a polymeric material. The method, further comprising: selecting the barrier material such that a coefficient of thermal expansion of the barrier material is substantially the same as the coefficient of thermal expansion of the ceramic layer. The method, wherein: the metal is plated with a non-oxidizing material; and after cooling, the barrier material does not physically contact the non-oxidizing material. The method, wherein the ceramic substrate comprises one of aluminum oxide, aluminum nitride, zirconia-toughened aluminum oxide, aluminum nitride, silicon nitride, and beryllium oxide. The method, further comprising: assembling the metal-ceramic substrate. The method, wherein: a melting temperature of the barrier material defines the flow point; the melting temperature of the barrier material is less than the melting temperature of the metal and of the ceramic layer; and heating the barrier material comprises baking the metal-ceramic substrate in an oven set to a temperature exceeding the melting temperature of the barrier material but not exceeding the melting temperature of the metal or the ceramic layer.

A method, comprising: smoothing a surface layer of a ceramic layer of a metal-ceramic substrate, wherein: the metal-ceramic substrate comprises: the ceramic layer; and the metallic layer, comprising: a metal joined to a surface of the ceramic layer, and trenches separating portions of the metal through which portions of the surface of the ceramic layer is exposed, the smoothing comprises: polishing the surface layer of the ceramic layer until a surface roughness of the ceramic layer is no more than 0.10 microns Ra.

The method, wherein the ceramic substrate comprises one of aluminum oxide, aluminum nitride, zirconia-toughened aluminum oxide, aluminum nitride, silicon nitride, and beryllium oxide. The method, wherein the ceramic substrate comprises a ceramic purity of at least 90%, at least 96%, or at least 99%. The method, wherein the surface layer of the ceramic layer comprises a vol.% of voids in the surface layer of no more than 8 vol.%, 7 vol.%, 5 vol.%, or 3 vol.%. The method, further comprising: assembling the metal-ceramic substrate.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, or a combination thereof. Additionally, the words "herein," "above," "below," and words of similar import, when used in this application, refer to this application as a whole and not to any particular portions of this application. Where the context permits, words in the above Detailed Description using the singular or plural number may also include the plural or singular number, respectively. The word "or," in reference to a list of two or more items, covers all of the following interpretations of the word: any of the items in the list, all of the items in the list, and any combination of the items in the list.

The phrases "in some embodiments," "according to some embodiments," "in the embodiments shown," "in other embodiments," and the like generally mean the particular feature, structure, or characteristic following the phrase is included in at least one implementation of the present technology and may be included in more than one implementation. In addition, such phrases do not necessarily refer to the same embodiments or different embodiments.

The above Detailed Description of examples of the technology is not intended to be exhaustive or to limit the technology to the precise form disclosed above. While specific examples for the technology are described above for illustrative purposes, various equivalent modifications are possible within the scope of the technology, as those skilled in the relevant art will recognize. For example, while processes or blocks are presented in a given order, alternative implementations may perform routines having steps, or employ systems having blocks, in a different order, and some processes or blocks may be deleted, moved, added, subdivided, combined, and/or modified to provide alternative or subcombinations. Each of these processes or blocks may be implemented in a variety of different ways. Also, while processes or blocks are at times shown as being performed in series, these processes or blocks may instead be performed or implemented in parallel or may be performed at different times. Further any specific numbers noted herein are only examples: alternative implementations may employ differing values or ranges.

The teachings of the technology provided herein can be applied to other systems, not necessarily the system described above. The elements and acts of the various examples described above can be combined to provide further implementations of the technology. Some alternative implementations of the technology may include not only additional elements to those implementations noted above, but also may include fewer elements.

These and other changes can be made to the technology in light of the above Detailed Description. While the above description describes certain examples of the technology, and describes the best mode contemplated, no matter how detailed the above appears in text, the technology can be practiced in many ways. Details of the system may vary considerably in its specific implementation, while still being encompassed by the technology disclosed herein. As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the above Detailed Description section explicitly defines such terms. Accordingly, the actual scope of the technology encompasses not only the disclosed examples, but also all equivalent ways of practicing or implementing the technology under the claims.

To reduce the number of claims, certain aspects of the technology are presented below in certain claim forms, but the applicant contemplates the various aspects of the technology in any number of claim forms. For example, while only one aspect of the technology is recited as a computer-readable medium claim, other aspects may likewise be embodied as a computer-readable medium claim, or in other forms, such as being embodied in a means-plus-function claim. Any claims intended to be treated under 35 U.S.C. § 112(f) will begin with the words "means for" but use of the term "for" in any other context is not intended to invoke treatment under 35 U.S.C. § 112(f). Accordingly, the applicant reserves the right to pursue additional claims after filing this application to pursue such additional claim forms, in either this application or in a continuing application.

## Claims

1. A power electronic module, comprising:
a ceramic layer;
a metallic layer comprising:
a metal joined to the ceramic layer, and
trenches extending a depth of the metal and separating the metal into portions such that one side of the trenches is defined by a surface of the ceramic layer and two opposite sides of the trenches are defined by the metal; and
a barrier material disposed within the trenches of the metallic layer, wherein:
the barrier material is bonded to at least a portion of the surface of the ceramic layer defining the one side of the trenches, and
the barrier material does not physically contact the metal defining the two opposite sides of the trenches once bonded to the surface of the ceramic layer.

2. The power electronic module of claim 1, wherein:
the metal is plated with a non-oxidizing material; and
the barrier material does not physically contact the non-oxidizing material once bonded to the surface of the ceramic layer.

3. The power electronic module of claim 1 or 2, at least one of:
wherein the barrier material comprises a glass, a glass-ceramic, a polymer, or a combination thereof;
wherein a coefficient of thermal expansion of the barrier material is substantially the same as the coefficient of thermal expansion of the ceramic layer;
wherein the metal is one of copper, aluminum, and a metal alloy; and
wherein the ceramic layer comprises one of aluminum oxide, aluminum nitride, zirconia-toughened aluminum oxide, aluminum nitride, silicon nitride, and beryllium oxide.

4. The power electronic module of one of claims 1 to 3, further comprising:
a housing configured to seal internal components of the power electronic module from gas and air permeation.

5. A method, comprising:
smoothing a surface layer of a portion of a ceramic layer of a power electronic module, wherein:
the power electronic module comprises:
the ceramic layer; and
a metallic layer, comprising:
a metal joined to portions of a surface of the ceramic layer, and
trenches separating portions of the metal through which the surface of the ceramic layer is exposed,
the smoothing comprises:
melting the surface layer of at least a portion of the exposed surface of the ceramic layer in the trenches; and
allowing the melted surface layer to harden such that the at least the portion of the exposed surface of the ceramic layer comprises a surface roughness less than the surface roughness of unsmoothed portions of the ceramic layer.

6. The method of claim 5, wherein the melting the surface layer comprises applying a chemical to the at least the portion of the exposed surface of the ceramic layer.

7. The method of claim 5 or 6, wherein the melting the surface layer comprises:
applying a directed energy to the at least the portion of the exposed surface of the ceramic layer.

8. The method of claim 7, wherein the applying the directed energy comprises:
directing a beam of a laser along the trench.

9. The method of claim 8, wherein the laser is a type of laser that melts the ceramic layer and does not melt the metal.

10. The method of claim 7, wherein the applying the directed energy comprises:
avoiding applying the directed energy to the metal.

11. The method of one of claims 5 to 10, wherein the ceramic layer comprises one of aluminum oxide, aluminum nitride, zirconia-toughened aluminum oxide, aluminum nitride, silicon nitride, and beryllium oxide.

12. A power electronic module, comprising:
a ceramic layer comprising a surface having a surface roughness of no more than 0.10 microns Ra;
a metallic layer comprising:
a metal joined to the surface of the ceramic layer, and
trenches extending a depth of the metal and separating the metal into portions such that one side of the trenches is defined by the surface of the ceramic layer and two opposite sides of the trenches are defined by the metal.

13. The power electronic module of claim 12, at least one of:
wherein the ceramic layer comprises one of aluminum oxide, aluminum nitride, zirconia-toughened aluminum oxide, aluminum nitride, silicon nitride, and beryllium oxide;
wherein the surface of the ceramic layer is polished; and
wherein the surface comprises less than 5 vol.% voiding.

14. The power electronic module of claim 12 or 13, further comprising:
a housing configured to seal internal components of the power electronic module from gas and air permeation.

15. The power electronic module of claim 14, further comprising:
a silicone-based potting material disposed within the housing.
